# EUROPÄISCHE PATENTSCHRIFT

(11) **EP 4 154 292 B1**
(45) Veröffentlichungstag und Bekanntmachung des Hinweises auf die Patenterteilung: **04.03.2026**
(21) Anmeldenummer: 21716103.3
(22) Anmeldetag: 25.03.2021
(51) Int. Cl.: H01J 37/32

(54) **MIKROWELLENBEHANDLUNGSEINRICHTUNG**
MICROWAVE TREATMENT DEVICE
DISPOSITIF DE TRAITEMENT PAR MICRO-ONDES

(30) Priorität: 19.05.2020 DE 102020113578
(43) Veröffentlichungstag der Anmeldung: 29.03.2023
(73) Patentinhaber: Muegge GmbH, 64385 Reichelsheim (DE)
(72) Erfinder: GORATH, Moritz Johann, 64385 Reichelsheim (DE)
(74) Vertreter: Paul & Albrecht Patentanwälte PartG mbB
(86) Internationale Anmeldenummer: PCT/EP2021/057760
(87) Internationale Veröffentlichungsnummer: WO 2021/233597

(56) Entgegenhaltungen:
- EP-A2- 0 459 177
- WO-A1-2011/125470
- WO-A2-99/12184
- DE-A1- 4 240 104
- KR-A- 20070 070 593
- US-A1- 2009 159 214
- US-A1- 2017 133 202

## Beschreibung

Die Erfindung betrifft eine Mikrowellenbehandlungseinrichtung mit einer Mikrowellenabstrahleinrichtung, mit welcher Mikrowellenstrahlung in einen Behandlungsraum eingestrahlt oder darin abgestrahlt werden kann.

Aus der Praxis sind verschiedene Mikrowellenbehandlungseinrichtungen bekannt, die für ganz unterschiedliche Zwecke und in ganz unterschiedlichen Anwendungsbereichen verwendet werden können. Mikrowellenbehandlungseinrichtungen können dazu verwendet werden, ein Objekt durch Bestrahlung mit Mikrowellen zu erwärmen, beziehungsweise zu erhitzen. Derartige Mikrowellenbehandlungseinrichtungen werden beispielsweise bei der kurzzeitigen Erhitzung und Sterilisation von vorbereiteten oder fertig zubereiteten Nahrungsmitteln oder aber zu deren Erwärmung unmittelbar vor deren Verzehr eingesetzt. Andere Mikrowellenbehandlungseinrichtungen sind dafür vorgesehen und ausgelegt, in einer Behandlungskammer ein mit Hilfe von Mikrowellenstrahlung aufrechterhaltenes Plasma zu erzeugen, um beispielsweise ein zu behandelndes Objekt in der Behandlungskammer mit einer plasmainduzierten Beschichtung zu versehen.

Dabei kann das Objekt vor dessen Behandlung in eine Behandlungskammer eingebracht und die Behandlungskammer während der Behandlungsdauer verschlossen werden, um beispielsweise einen unerwünschten Austritt von Mikrowellenstrahlung aus der verschlossenen Behandlungskammer während der Behandlungsdauer zu vermeiden. Es sind ebenfalls Mikrowellenbehandlungseinrichtungen bekannt, bei denen die Behandlungskammer eine Eingangsöffnung und eine Ausgangsöffnung aufweist und das zu behandelnde Objekt mit einer Fördereinrichtung in die Behandlungskammer hinein und nach der erfolgten Behandlung wieder aus der Behandlungskammer herausbefördert werden kann, wobei auch eine kontinuierliche Beförderung des Objekts durch die Behandlungskammer während der Behandlungsdauer möglich ist.

Ein wesentlicher Aspekt der derartigen Mikrowellenbehandlungseinrichtungen ist die Erzeugung der Mikrowellenstrahlung, die in der Behandlungskammer für die Behandlung des zu behandelnden Objektes zur Verfügung gestellt werden soll. Die Erzeugung der Mikrowellenstrahlung erfolgt regelmäßig außerhalb der Behandlungskammer. In vielen Fällen wird die Mikrowellenstrahlung durch Hohlleiter von einer Mikrowellenerzeugungsvorrichtung zu der Behandlungskammer hingeführt.

Die Mikrowellenstrahlung kann beispielsweise unmittelbar außerhalb der Behandlungskammer von Hornstrahlern abgestrahlt und durch Öffnungen in der Behandlungskammer in die Behandlungskammer eingestrahlt werden. Die Öffnungen sind dabei üblicherweise mit einem mikrowellendurchlässigen Material wie beispielsweise Quarzglas verschlossen, um die Behandlungskammer mit einem geeigneten Medium befüllen zu können, welches die gewünschte Behandlung des Objekts ermöglicht oder zumindest unterstützt. Darüber hinaus können in einer derart verschlossenen Behandlungskammer vorteilhafte Druckverhältnisse wie beispielsweise ein Überdruck oder Vakuum erzeugt werden. Es sind ebenfalls Mikrowellenbehandlungseinrichtungen bekannt, bei denen die Mikrowellenstrahlung durch geeignete Antennen, beispielsweise durch in die Behandlungskammer ragende Stabantennen oder durch Hohlleitersysteme in die Behandlungskammer hineingeführt und in der Behandlungskammer abgestrahlt werden. Eine Einkopplung der Mikrowellenstrahlung von außerhalb der Behandlungskammer ist dann nicht erforderlich.

In vielen Fällen ist die Behandlungskammer als Resonator ausgebildet, um innerhalb der Behandlungskammer eine möglichst gleichbleibende und präzise bekannte Strahlungsverteilung der Mikrowellenstrahlung bewirken zu können. Bei einer durch die Ausgestaltung der Mikrowellenabstrahleinrichtung und der Behandlungskammer fest vorgegebenen Strahlungsverteilung ist es kaum möglich, die Mikrowellenbehandlungseinrichtung an unterschiedliche Objekte oder Behandlungsverfahren anzupassen, um trotz unterschiedlicher Vorgaben jeweils eine möglichst effiziente Behandlung der Objekte zu ermöglichen.

Bei einigen aus der Praxis bekannten Mikrowellenbehandlungseinrichtungen kann die Mikrowellenabstrahleinrichtung beispielsweise hinsichtlich ihrer Anordnung oder Ausrichtung relativ zu der Behandlungskammer verändert werden, um unterschiedliche Strahlungsverteilungen innerhalb der Behandlungskammer zu bewirken, sodass eine Anpassung an unterschiedliche Objekte oder Behandlungsparameter möglich ist. Der Aufwand für eine derartige Umrüstung einer Mikrowellenbehandlungseinrichtung ist jedoch vergleichsweise hoch.

Die EP 0 459 177 A2 offenbart eine Mikrowellenbehandlungseinrichtung mit einem phasengesteuerten Antennen-Array, das von einem Festkörper-Mikrowellengenerator gespeist wird und als Anregungsquelle für Material- bzw. Plasmaprozesse dient. Das Antennen-Array umfasst eine Mehrzahl von Dipolantennen, die bei geeigneter Phasen- und Amplitudensteuerung konstruktiv interferieren.

Die WO 2011/125470 A1 offenbart eine Plasmabearbeitungsvorrichtung und ein zugehöriges Verfahren. Die Vorrichtung weist eine Bearbeitungskammer auf, in die ein Bearbeitungsgas eingelassen werden kann. Es ist ferner eine Mehrzahl von Mikrowellenerzeugungseinrichtungen vorgesehen, die jeweils über einen Wellenleiter mit einer Mikrowellenzu-führeinheit zum Zuführen von Mikrowellen in die Bearbeitungskammer verbunden sind. Die Mikrowellenerzeugungseinheiten, Wellenleiter und Mikrowellenzuführeinheiten bilden Plasmaerzeugungsmittel zum Erzeugen eines Plasmas aus dem Bearbeitungsgas in der Bearbeitungskammer. Mit einer Steuereinrichtung kann jede Komponente der Vorrichtung gesteuert werden.

Die US 2017/133202 A1 offenbart ein Verfahren zur Modifikation einer Reaktionsrate auf einem Halbleitersubstrat in einer Bearbeitungskammer, welche ein phasengesteuertes Array von Mikrowellenantennen nutzt.

Die KR 2007 0070 593 A offenbart eine Mikrowellenerzeugungsvorrichtung und eine Plasmaerzeugungsvorrichtung mit einer solchen. Die Mikrowellenerzeugungsvorrichtung umfasst einen Modulator und einen Verstärker, welcher das Mikrowellensignal des Modulators empfängt und verstärkt. Dieses wird über einen Wellenleiter an eine Mehrzahl von Antennen übertragen, die in einer Bearbeitungskammer der Vorrichtung angeordnet sind.

Die WO 99/12184 A2 offenbart eine Plasmaerzeugungsvorrichtung mit einem Mikrowellenapplikator zur Erzeugung eines Mikrowellenfeldes in einer Plasmakammer. Die Vorrichtung weist ein zweidimensionales Array von Mikrowellenhornstrahlern auf.

In der US 2009/159214 A1 ist eine Mikrowellenplasmaquelle beschrieben, die eine Mehrzahl von Antennen aufweist, über welche Mikrowellen in eine Bearbeitungskammer der Vorrichtung eingestrahlt werden können.

Aus der DE 42 40 104 A1 geht eine Vorrichtung zum Erwärmen/Trocknen mit Mikrowellen hervor, die eine Mehrzahl von Patchantennen umfasst.

Es wird deshalb als eine Aufgabe der vorliegenden Erfindung angesehen, eine aus dem Stand der Technik bekannte Mikrowellenbehandlungseinrichtung so auszugestalten, dass mit möglichst geringem Aufwand und in kurzer Zeit eine Veränderung der Strahlungsverteilung innerhalb eines Behandlungsraumes und dadurch eine Anpassung der Strahlungsverteilung innerhalb des Behandlungsraumes an verschiedene Objekte oder Behandlungsparameter ermöglicht wird.

Diese Aufgabe wird erfindungsgemäß gelöst durch eine Mikrowellenbehandlungseinrichtung gemäß Anspruch 1. Durch die Verwendung einer Gruppenantenne mit mehreren Einzelstrahlern, die individuell angesteuert werden können, kann eine sich durch die Überlagerung der von den Einzelstrahlern abgestrahlten Mikrowellenstrahlung ergebende Intensitätsverteilung innerhalb des Behandlungsraums in einfacher Weise variiert und an die jeweiligen Anforderungen, beziehungsweise Vorgaben angepasst werden. Dabei ist es nicht erforderlich, dass eine Verlagerung der Mikrowellenabstrahleinrichtung relativ zu dem Behandlungsraum oder eine mechanische Anpassung der Mikrowellenabstrahleinrichtung vorgenommen wird. Die Abmessungen der einzelnen Einzelstrahler sowie deren Anzahl und Anordnung innerhalb der mindestens einen Gruppenantenne können weitgehend beliebig vorgegeben und an den im Einzelfall gewünschten Behandlungsraum sowie an den jeweiligen Verwendungszweck angepasst sein.

Es hat sich gezeigt, dass ein einzelner Einzelstrahler üblicherweise keine für eine Mikrowellenbehandlungseinrichtung besonders geeignete Abstrahlcharakteristik aufweist. Bei einer Kombination von mehreren Einzelstrahlern zu einer Gruppenantenne können die einzelnen Einzelstrahler jedoch so angesteuert und zur Abstrahlung von Mikrowellen veranlasst werden, dass mit der Gruppenantenne eine für eine Mikrowellenbehandlungseinrichtung sehr vorteilhafte Abstrahlcharakteristik realisiert werden kann. Dabei kann bereits mit einer Gruppenantenne, die lediglich 3 x 3 oder sogar weniger Einzelstrahler aufweist, eine für bestimmte Anwendungsfälle geeignete Abstrahlcharakteristik erzeugt werden. Für viele Anwendungsfälle dürfte jedoch mit Gruppenantennen, die beispielsweise 5 x 5 oder mehr matrixförmig angeordnete Einzelstrahler aufweisen, eine stärker beeinflussbare und besser an den jeweiligen Anwendungsfall anpassbare Abstrahlcharakteristik erzielt werden können. Es sind neben quadratischen Anordnungen auch rechteckförmige oder polygonale bzw. kreisförmige oder ovale Anordnungen der Einzelstrahler in einer Gruppenantenne sowie die Kombination von mehreren gleichartigen oder unterschiedlich ausgestalteten Gruppenantennen möglich.

Die Abmessungen eines Einzelstrahlers sind zweckmäßigerweise an die jeweils verwendete Frequenz der abzustrahlenden Mikrowellen angepasst und entsprechen beispielsweise mindestens einer Wellenlänge von X/4. Bei einer für viele Anwendungsfälle geeigneten Frequenz der Mikrowellen von 2.45 GHz betragen die Abmessungen eines Einzelstrahlers etwa 3 x 3 cm. Eine näherungsweise rechteckige oder quadratische Grundfläche wird dabei als vorteilhaft erachtet. Besonders vorteilhafte Abstrahlungseigenschaften einer Gruppenantenne können mit Einzelstrahlern mit einer näherungsweise viereckigen Grundfläche erzielt werden, wobei bei zwei einander gegenüberliegenden Ecken die Grundfläche statt durch die betreffende Ecke durch eine in einem Winkel von 45° zu den angrenzenden Seitenkanten verlaufende Diagonale begrenzt ist. Die Einzelstrahler werden in vorteilhafter Weise so dimensioniert und angesteuert, dass eine zirkular polarisierte Mikrowelle abgestrahlt wird.

Durch die Verwendung von mindestens einer Gruppenantenne ist es grundsätzlich möglich, dass der Behandlungsraum nicht durch ein Gehäuse oder beispielsweise eine Vakuumkammer begrenzt werden muss. Mit einer Gruppenantenne kann die abgestrahlte Mikrowellenleistung in einem räumlichen Bereich im Abstand von der Gruppenantenne fokussiert werden, ohne dass beispielsweise mit einem elektrisch leitenden Gehäuse Resonanzbedingungen vorgegeben werden müssen. So kann beispielsweise mit den von der Gruppenantenne abgestrahlten Mikrowellen ein Objekt erwärmt werden, welches sich in der Nähe der Gruppenantenne befindet, ohne dass ein abgeschlossenes Gehäuse notwendig ist.

Um eine unerwünschte Ausbreitung von Mikrowellen über den für eine Behandlung eines Objekts benötigten Behandlungsraum hinaus zu begrenzen kann die Verwendung einer die Ausbreitung von Mikrowellen über den Behandlungsraum behindernde oder verhindernde Behandlungskammer zweckdienlich sein. Bereits mit einer einzelnen Gruppenantenne und insbesondere bei einer Verwendung von mehreren Gruppenantennen kann die insgesamt abgestrahlte Mikrowellenleistung innerhalb eines Bereichs variabel ausgerichtet und fokussiert werden, sodass in einfacher Weise eine Anpassung der abgestrahlten Mikrowellenleistung an unterschiedliche Objekte oder Umgebungsbedingungen möglich ist. Es kann bei Verwendung von lediglich einer Gruppenantenne zweckmäßig sein, dass die Gruppenantenne und die Behandlungskammer der Mikrowellenbehandlungseinrichtung hinsichtlich der jeweiligen Abmessungen sowie der Anordnung der Gruppenantenne innerhalb der Behandlungskammer derart vorgegeben und aneinander angepasst sind, dass mit der Gruppenantenne die Mikrowellenstrahlung innerhalb der Behandlungskammer so abgestrahlt werden kann, dass das zu behandelnde Objekt vollständig und effizient mit Mikrowellenstrahlung bestrahlt werden kann.

Wenn die Mikrowellenbehandlungseinrichtung zur Erzeugung eines Plasmas verwendet wird kann eine Behandlungskammer verwendet werden, die hinsichtlich der Behandlung von Objekten mit dem Plasma und einer Begrenzung des Plasmas in der Behandlungskammer ausgelegt und angepasst ist, ohne dass eine aufwendige Einkopplung der von der Gruppenantenne abgestrahlten Mikrowellen in die Behandlungskammer notwendig wird.

In den meisten praxisrelevanten Fällen sind die Mikrowellenbehandlungseinrichtungen so ausgestaltet, dass ein Abstand zwischen der mindestens einen Gruppenantenne und dem zu behandelnden Objekt in der Größenordnung der charakteristischen Wellenlänge der mit den Einzelstrahlern der Gruppenantenne abgestrahlten Mikrowellenstrahlung liegt. Das zu behandelnde Objekt befindet sich dann in dem Nahfeld, beziehungsweise in einem Zwischenbereich zwischen dem Nahfeld und dem Fernfeld der Gruppenantenne, sodass eine Rückwirkung der Umgebung und insbesondere des zu behandelnden Objekts auf die charakteristische Abstrahlung der Mikrowellen mit der mindestens einen Gruppenantenne erfolgen kann und berücksichtigt werden sollte.

Die einzelnen Einzelstrahler können auf verschiedene Weisen mit der für die Abstrahlung der Mikrowellenstrahlung erforderlichen Energie versorgt werden. Die Energie kann über einen elektromagnetischen Wellenleiter wie beispielsweise einen Koaxialleiter oder eine Streifenleitung den einzelnen Einzelstrahlern zugeführt werden. Es ist ebenfalls denkbar, dass die Energie kontaktlos, beziehungsweise ohne einen elektromagnetischen Wellenleiter zu den einzelnen Einzelstrahlern übertragen wird, beispielsweise mit induktiven oder kapazitiven Übertragungsverfahren.

Gemäß einer vorteilhaften Ausgestaltung des Erfindungsgedankens ist vorgesehen, dass mit der Mikrowellensteuereinrichtung für jeden Einzelstrahler eine Amplitude der Mikrowellenabstrahlung vorgegeben werden kann. Es ist ebenfalls denkbar, dass entweder für die mindestens eine Gruppenantenne oder aber für jeden Einzelstrahler eine Frequenz der abgestrahlten Mikrowellenstrahlung vorgegeben und gegebenenfalls während eines Betriebs der Mikrowellenbehandlungseinrichtung auch verändert werden kann. Durch eine geeignete Veränderung und Vorgabe der vorangehend genannten Parameter ergibt sich die Möglichkeit, die Position und Intensität von Maxima und Minima der resultierenden Verteilung der Mikrowellenstrahlung innerhalb der Behandlungskammer während einer Behandlungsdauer eines zu behandelnden Objektes nahezu beliebig vorzugeben und gegebenenfalls auch während der Behandlungsdauer zu verändern. Damit sind auch neuartige Behandlungsverfahren für das zu behandelnde Objekt möglich.

So kann beispielsweise während der Behandlungsdauer die Anordnung von einem Intensitätsmaximum der Mikrowellenstrahlung relativ zu dem zu behandelnden Objekt verändert werden, und zwar unabhängig davon, ob das zu behandelnde Objekt ortsfest innerhalb der Behandlungskammer angeordnet ist oder aber während der Behandlungsdauer mit einer Fördereinrichtung durch die Behandlungskammer hindurchbewegt wird.

Die Veränderung einer Phase oder Amplitude der Mikrowellenabstrahlung eines Einzelstrahlers kann mit einer geeigneten Mikrowellensteuereinrichtung in einfacher Weise bewirkt und vorgegeben werden. Die Mikrowellensteuereinrichtung weist zu diesem Zweck für jeden Einzelstrahler eine zugeordnete Einrichtung zur Veränderung und Anpassung einer Phase und gegebenenfalls auch einer Amplitude auf, mit welchem die Phase und gegebenenfalls auch die Amplitude der einem Einzelstrahler zugeführten elektromagnetischen Welle beeinflusst und verändert werden kann. Dadurch können die Phasen der mit den Einzelstrahlern abgestrahlten Mikrowellenstrahlung relativ zueinander so vorgegeben werden, dass sich bei der Überlagerung der von den Einzelstrahlern abgestrahlten Mikrowellenstrahlung eine gewünschte Intensitätsverteilung des Strahlungsfelds innerhalb der Behandlungskammer ausbildet. Es ist optional auch möglich und für verschiedene Anwendungsfälle vorteilhaft, wenn mit der Mikrowellensteuereinrichtung für jeden Einzelstrahler innerhalb eines Frequenzbereichs eine Frequenz der Mikrowellenabstrahlung vorgegeben werden kann. Aus der Praxis sind Mikrowellen-Generatoren bekannt, die auf der Basis von Festkörperbauteilen Mikrowellen mit einer Frequenz erzeugen können, die innerhalb eines durch den Mikrowellen-Generator vorgegebenen Frequenzbereichs beliebig ausgewählt und vorgegeben werden können. Es ist auch eine Veränderung der Frequenz während des Betriebs möglich. Eine Veränderung der geometrischen Abmessungen derartiger Festkörper-Generatoren ist dabei nicht erforderlich, sodass mit der Festkörperelektronik automatisiert und gegebenenfalls innerhalb einer kurzen Zeitdauer Veränderungen an der Frequenz der damit erzeugten Mikrowellenstrahlung vorgenommen werden können. Mit den verschiedenen Möglichkeiten zur Beeinflussung der Phase, der Amplitude oder der Frequenz der Einzelstrahler kann die Abstrahlcharakteristik einer einzelnen Gruppenantenne vielfältig beeinflusst und sehr individuell an unterschiedliche Anwendungsfälle angepasst werden.

Die mindestens eine Gruppenantenne kann außerhalb einer Behandlungskammer oder aber innerhalb der Behandlungskammer angeordnet sein. Die Behandlungskammer kann während der Dauer einer Behandlung des zu behandelnden Objekts geschlossen sein, um mit Hilfe eines Prozessfluids wie beispielsweise ein geeignetes Prozessgas oder Wasser geeignete Umgebungsbedingungen für das zu behandelnde Objekt während der Behandlungsdauer vorgeben zu können. Falls die Gruppenantenne außerhalb einer geschlossenen Behandlungskammer angeordnet ist, weist die Behandlungskammer zweckmäßigerweise ein mikrowellentransparentes Fenster auf, durch welches die von der Gruppenantenne abgestrahlte Mikrowellenstrahlung in die Behandlungskammer eingestrahlt werden kann.

In vorteilhafter Weise ist optional vorgesehen, dass mindestens eine Gruppenantenne innerhalb eines die Behandlungskammer umgebenden Gehäuses aus einem elektrisch leitenden Material angeordnet ist. Mit der innerhalb der Behandlungskammer angeordneten Gruppenantenne kann die Mikrowellenstrahlung innerhalb der Behandlungskammer erzeugt und darin abgestrahlt werden. Durch das umgebende Gehäuse aus einem elektrisch leitenden Material kann eine unerwünschte Abstrahlung von Mikrowellenstrahlung in die Umgebung der Behandlungskammer weitestgehend reduziert werden. Auf diese Weise ist eine vergleichsweise effiziente Behandlung des zu behandelnden Objekts mit Mikrowellenstrahlung möglich, wobei gleichzeitig erreicht und gegebenenfalls gewährleistet werden kann, dass keine Mikrowellenstrahlung, beziehungsweise lediglich ein sehr geringer Anteil der von der Gruppenantenne erzeugten Mikrowellenstrahlung aus der Behandlungskammer in die Umgebung austreten kann.

Um einen kontinuierlichen Dauerbetrieb der Mikrowellenbehandlungseinrichtung zu ermöglichen ist gemäß einer Ausgestaltung des Erfindungsgedankens vorgesehen, dass die Behandlungskammer eine Eingangsöffnung und eine Ausgangsöffnung zum Einbringen und zum Herausbringen des zu behandelnden Objekts sowie eine Fördereinrichtung aufweist, mit welcher das zu behandelnde Objekt durch die Eingangsöffnung in die Behandlungskammer und nach einer Behandlung mit Mikrowellenstrahlung durch die Ausgangsöffnung aus der Behandlungskammer heraus befördert werden kann. In Abhängigkeit von der jeweiligen Ausgestaltung der Behandlungskammer können die Eingangsöffnung und die Ausgangsöffnung durch eine einzige Öffnung in der Behandlungskammer gebildet sein und die Fördereinrichtung das zu behandelnde Objekt durch diese eine Öffnung in die Behandlungskammer hinein und anschließend nach der Behandlungsdauer wieder aus der Behandlungskammer herausbefördern. In vielen Fällen ist es jedoch zweckmäßig, dass die Fördereinrichtung ein von einer Eingangsöffnung bis zu einer davon beabstandeten Ausgangsöffnung durch die Behandlungskammer hindurch verlaufendes Förderband oder einen Förderweg aufweist, sodass die zu behandelnden Objekte der Reihe nach und kontinuierlich durch die Eingangsöffnung in die Behandlungskammer hineinbefördert, innerhalb der Behandlungskammer mit der Mikrowellenstrahlung behandelt und anschließend durch die Ausgangsöffnung wieder aus der Behandlungskammer herausbefördert werden können.

Mit der Gruppenantenne kann dabei wahlweise kontinuierlich oder in zeitlichen Abständen jeweils für eine vorgegebene Behandlungsdauer Mikrowellenstrahlung abgestrahlt werden. Die Eingangsöffnung und die Ausgangsöffnung können teilweise oder vollständig verschlossen, beziehungsweise abgedeckt werden, sofern sich kein zu behandelndes Objekt im Bereich der Eingangsöffnung oder der Ausgangsöffnung befindet, um den Anteil von unerwünscht durch die Eingangsöffnung oder Ausgangsöffnung austretender Mikrowellenstrahlung zu reduzieren. Die Fördereinrichtung kann ein mikrowellentransparentes Förderband aufweisen, das durch die Behandlungskammer umläuft und auf welchem die zu behandelnden Objekte angeordnet und durch die Behandlungskammer hindurchbefördert werden können.

Gemäß einer besonders vorteilhaften Ausgestaltung des Erfindungsgedankens ist vorgesehen, dass mehrere Gruppenantennen innerhalb der Behandlungskammer so angeordnet sind, dass das zu behandelnde Objekt aus unterschiedlichen Richtungen mit der jeweils von einer Gruppenantenne abgestrahlten Mikrowellenstrahlung bestrahlt werden kann. Die mehreren Gruppenantennen können beispielsweise mit unterschiedlichen Frequenzen der Mikrowellenstrahlung betrieben werden. Häufig verwendete Frequenzbereiche sind beispielsweise die Bereiche zwischen 900 und 930 MHz, zwischen 2,4 und 2,5 GHz oder zwischen 5,725 und 5,875 GHz. Für Mikrowellenstrahlung in diesen Frequenzbereichen sind zahlreiche verschiedene Mikrowellenerzeugungsvorrichtungen verfügbar und handelsüblich erhältlich. Mit Mikrowellenstrahlung aus diesen Frequenzbereichen können beispielsweise Nahrungsmittel erwärmt oder sterilisiert werden. Es sind jedoch auch andere Frequenzbereiche oder Verwendungszwecke denkbar.

Durch die Anordnung von mehreren Gruppenantennen innerhalb der Behandlungskammer kann das zu behandelnde Objekt aus unterschiedlichen Richtungen mit Mikrowellenstrahlung bestrahlt werden, wodurch beispielsweise eine raschere und gleichmäßigere Erwärmung des zu behandelnden Objektes im Vergleich mit lediglich aus einer Richtung abgestrahlter Mikrowellenstrahlung möglich ist. Die mehreren Gruppenantennen können baugleich sein und lediglich innerhalb der Behandlungskammer unterschiedlich angeordnet und ausgerichtet sein, wodurch sich der Herstellungsaufwand für die mehreren Gruppenantennen reduzieren lässt. Es ist ebenfalls denkbar, dass die mehreren Gruppenantennen unterschiedliche Abmessungen und Formgebungen aufweisen, um unterschiedliche Strahlungscharakteristiken bei der Abstrahlung der Mikrowellenstrahlung aufweisen können, die vorteilhaft zu der Behandlung der zu behandelnden Objekte eingesetzt werden können. Die mehreren Gruppenantennen können auch mit verschiedenen Frequenzen betrieben und entsprechend unterschiedliche Mikrowellenstrahlung abstrahlen.

Im Hinblick auf eine möglichst kostengünstige Herstellung sowie einen möglichst zuverlässigen Betrieb der Mikrowellenabstrahleinrichtung ist vorgesehen, dass die Einzelstrahler der mindestens einen Gruppenantenne jeweils als Patchantenne ausgebildet sind. Eine Patchantenne weist eine üblicherweise rechteckige oder quadratische Metallfläche auf, wobei eine Länge einer Längsseite der rechteckigen Metallfläche zweckmäßiger Weise an die charakteristische Wellenlänge der Mikrowellenstrahlung angepasst ist, die von der Patchantenne abgestrahlt werden soll. Es sind auch Patchantennen mit einer ebenflächigen oder gekrümmten Formgebung möglich, die von einer rechteckigen oder quadratischen Formgebung abweichen. Durch die Anpassung einer geeigneten Formgebung kann die Abstrahlcharakteristik der Patchantenne beeinflusst und in geeigneter Weise vorgegeben werden. Es ist ebenfalls denkbar, dass die Patchantennen innerhalb der mindestens einen Gruppenantenne oder bei mehreren jeweils einheitlich ausgestalteten Gruppenantennen eine unterschiedliche bzw. eine voneinander abweichende Formgebung aufweisen. Eine einzelne Patchantenne und insbesondere eine zellenförmige oder matrixförmige Anordnung mehrerer Patchantennen innerhalb der mindestens einen Gruppenantenne kann mit bekannten Herstellungsverfahren kostengünstig hergestellt werden. Die Patchantennen benötigen aufgrund der im Wesentlichen aus ebenflächigen Strukturen und Komponenten zusammengesetzten Patchantenne lediglich einen geringen Bauraum. Zudem können die Patchantennen aus kostengünstigen Materialien hergestellt und weitgehend unempfindlich gegenüber den üblicherweise innerhalb der Behandlungskammer herrschenden Umgebungsbedingungen ausgebildet sein.

Innerhalb der mindestens einen Gruppenantenne können auch voneinander abweichende Patchantennenstrukturen ausgebildet und gemeinsam betrieben werden. Es ist ebenfalls denkbar, dass auch mehrlagige Abfolgen von Schichten aus elektrisch leitfähigem Metall und nicht elektrisch leitfähigen Dielektrika einen Einzelstrahler bilden. Innerhalb einer Gruppenantenne können auch zusätzliche Komponenten angeordnet sein, um die von der Gruppenantenne abgestrahlte Mikrowellenstrahlung in geeigneter Weise auszurichten und unerwünschte Reflektionen zu vermeiden.

Einer vorteilhaften Ausgestaltung des Erfindungsgedankens zufolge ist vorgesehen, dass eine Antennenlinseneinrichtung zwischen der mindestens einen Gruppenantenne und dem zu behandelnden Objekt angeordnet ist, mit welchem von der Gruppenantenne oder von mindestens einem Einzelstrahler der Gruppenantenne abgestrahlte Mikrowellenstrahlung umgelenkt oder fokussiert werden kann. Zu diesem Zweck können beispielsweise einige Einzelstrahler oder alle Einzelstrahler einer Gruppenantenne teilweise oder vollständig mit einem mikrowellenleitenden Material wie beispielsweise Quarzglas, Saphirglas oder Polytetrafluorethylen bedeckt sein, um die Strahlungseigenschaften der Gruppenantenne zu beeinflussen. Mit einer derartigen Antennenlinseneinrichtung kann erreicht werden, dass der Anteil der von der Gruppenantenne in Richtung des zu behandelnden Objekts abgestrahlten Mikrowellenstrahlung erhöht und ein anderer Anteil der Mikrowellenstrahlung, der nicht zur Behandlung des zu behandelnden Objektes genutzt werden kann, reduziert wird.

Gemäß einer besonders vorteilhaften Ausgestaltung des Erfindungsgedankens ist vorgesehen, dass die Mikrowellenbehandlungseinrichtung mindestens eine Antileckage-Gruppenantenne aufweist, die derart ausrichtbar und ansteuerbar ist, dass durch die Eingangsöffnung und/oder durch die Ausgangsöffnung austretende Mikrowellenstrahlung der mindestens einen Gruppenantenne destruktiv überlagert und die austretende Intensität der Mikrowellenstrahlung dadurch veloziert wird. Auf diese Weise kann ein unerwünschtes Austreten von Mikrowellenstrahlung aus der Behandlungskammer heraus auch bei einer teilweise oder vollständig geöffneten Eingangsöffnung, beziehungsweise Ausgangsöffnung erheblich reduziert werden. Dadurch kann die Effizienz der Mikrowellenbehandlungseinrichtung verbessert werden, sodass mit einem geringeren Energieaufwand eine vergleichbare oder verbesserte Behandlung des zu behandelnden Objekts möglich ist. Zudem kann der konstruktive Aufwand verringert werden, der für einen sicheren Betrieb der Mikrowellenbehandlungseinrichtung und für eine angemessene Abschirmung der Umgebung von der dabei abgestrahlten Mikrowellenstrahlung erforderlich ist.

Es ist ebenfalls möglich, dass eine oder mehrere Antileckage- Gruppenantennen bei einer Mikrowellenbehandlungseinrichtung verwendet werden, die keine Behandlungskammer bzw. kein Gehäuse aufweist, welches einen Behandlungsraum umgibt. Die Antileckage-Gruppenantennen können dann so angeordnet und derart betrieben werden, dass die Ausbreitung der von den Gruppenantennen abgestrahlten Mikrowellenleistung über den Behandlungsraum hinweg in einer Raumrichtung oder in mehreren Raumrichtungen unterdrückt oder nahezu vollständig verhindert wird. Auf diese Weise kann durch eine geeignete Anordnung von Gruppenantennen und Antileckage-Gruppenantennen ein nicht durch ein Gehäuse begrenzter Behandlungsraum vorgegeben werden, innerhalb dessen die abgestrahlte Mikrowellenleistung zur Behandlung eines Objekts genutzt werden kann, und außerhalb dessen zumindest in einer oder in mehreren Raumrichtungen keine übermäßige weitere Ausbreitung der Mikrowellen erfolgt.

Nachfolgend werden exemplarische Ausführungsbeispiele des Erfindungsgedankens näher erläutert, die schematisch in der Zeichnung dargestellt sind. Es zeigt:
- Figur 1: eine Schnittansicht durch eine Behandlungskammer einer Mikrowellenbehandlungseinrichtung, durch welche zu behandelnde Objekte mit einer Fördereinrichtung hindurchbefördert werden und in welcher eine Gruppenantenne aus mehreren Einzelstrahlern angeordnet ist, mit denen jeweils Mikrowellenstrahlung abgestrahlt werden kann,
- Figur 2: eine Schnittansicht der in Figur 1 dargestellten Behandlungskammer längs eine Linie II-II in Figur 1, Figur 3 eine perspektivische Ansicht einer Gruppenantenne, die aus einer matrixförmigen Anordnung von 3 x 12 Einzelstrahlern besteht,
- Figur 4: eine perspektivische Ansicht einer räumlichen Verteilung der mit der Gruppenantenne abgestrahlten Mikrowellenleistungsdichte in einem Bereich in der Nähe der Gruppenantenne,
- Figur 5: eine Schnittansicht einer abgestrahlten E-Feld- Verteilung bei der in Figur 4 dargestellten räumlichen Verteilung der Mikrowellenleistungsdichte längs einer Linie V-V in Figur 4,
- Figur 6: eine perspektivische Darstellung einer räumlichen Verteilung der mit der Gruppenantenne abgestrahlten Mikrowellenleistungsdichte, die mit einer abweichenden Ansteuerung der einzelnen Einzelstrahler der Gruppenantenne erzeugt wird,
- Figur 7: eine Schnittansicht einer abgestrahlten E-Feld- Verteilung bei der in Figur 6 dargestellten räumlichen Verteilung der Mikrowellenleistungsdichte längs der Linie VII-VII in Figur 6,
- Figur 8: eine perspektivische Darstellung einer räumlichen Verteilung der mit der Gruppenantenne abgestrahlten Mikrowellenleistungsdichte, die mit einer wiederum abweichenden Ansteuerung der Einzelstrahler der Gruppenantenne erzeugt wird,
- Figur 9: eine Schnittansicht einer abgestrahlten E-Feld- Verteilung bei der in Figur 8 dargestellten räumlichen Verteilung der Mikrowellenleistungsdichte längs einer Linie IX-IX in Figur 8,
- Figur 10: eine perspektivische Darstellung einer räumlichen Verteilung der mit der Gruppenantenne abgestrahlten Mikrowellenleistungsdichte mit einer wiederum abweichenden Ansteuerung der Einzelstrahler der Gruppenantenne,
- Figur 11: eine Schnittansicht einer abgestrahlten E-Feld-Verteilung bei der in Figur 10 dargestellten räumlichen Verteilung der Mikrowellenleistungsdichte längs einer Linie XI-XI in Figur 10,
- Figur 12: eine schematische Draufsicht auf einen einzelnen Einzelstrahler,
- Figuren 13a bis 13c: jeweils eine Schnittansicht von verschiedenen Intensitätsverteilungen, die jeweils eine mit einer Gruppenantenne mit 5 x 5 Einzelstrahlern in unterschiedlichen Betriebsmodi erzeugten Abstrahlcharakteristik entsprechen, und
- Figur 14: eine Schnittansicht einer Intensitätsverteilung einer Abstrahlcharakteristik, welche mit drei jeweils in einem Winkel zu einander ausgerichteten Gruppenantennen erzeugt wird.

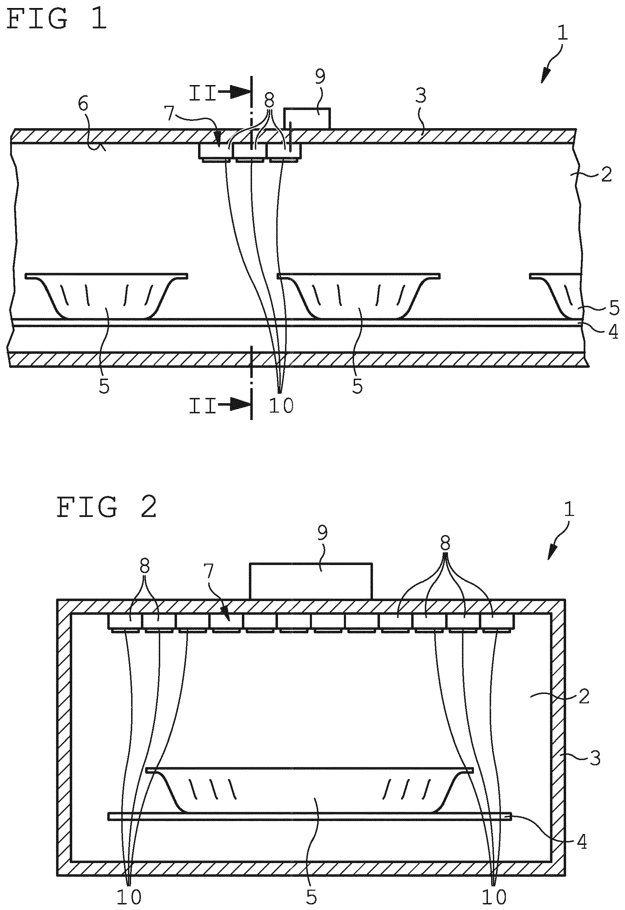

In den Figuren 1 und 2 ist eine erfindungsgemäß ausgestaltete Mikrowellenbehandlungseinrichtung 1 in zwei verschiedenen Schnittansichten dargestellt. Die Mikrowellenbehandlungseinrichtung 1 weist eine Behandlungskammer 2 auf, die von einem Gehäuse 3 aus einem elektrisch leitfähigen Material wie beispielsweise Metall umgeben ist. Durch die Behandlungskammer 2 hindurch verläuft ein Förderband 4 einer Fördereinrichtung. Auf dem Förderband 4 sind mehrere zu behandelnde Objekte 5 jeweils beabstandet zueinander angeordnet. Bei den Objekten 5 kann es sich beispielsweise um verschlossene Nahrungsmittelbehälter handeln, die mit einer vorbereiteten Mahlzeit befüllt sind, die mit Hilfe der Mikrowellenbehandlungseinrichtung 1 entweder vor einer Lagerung sterilisiert oder unmittelbar vor einem Verzehr erwärmt werden soll. Mit dem Förderband 4 werden die einzelnen Objekte 5 kontinuierlich durch die Behandlungskammer 2 hindurch befördert. An einer Innenwand 6 des die Behandlungskammer 2 umgebenden Gehäuses 3 ist eine Gruppenantenne 7 angeordnet. Die Gruppenantenne 7 weist eine Anzahl von matrixförmig angeordneten Einzelstrahlern 8 auf. Mit jedem Einzelstrahler 8 der Gruppenantenne 7 kann Mikrowellenstrahlung abgestrahlt werden. Die einzelnen Einzelstrahler 8 werden von einer Mikrowellensteuereinrichtung 9 angesteuert, sodass die Abstrahlung von Mikrowellenstrahlung der einzelnen Einzelstrahler 8 der Gruppenantenne 7 durch die Mikrowellensteuereinrichtung 9 unabhängig voneinander und für jeden Einzelstrahler 8 gesondert vorgegeben werden kann. Die von den Einzelstrahlern 8 der Gruppenantenne 7 während einer Behandlung der zu behandelnden Objekte 5 abgestrahlte Mikrowellenstrahlung überlagert sich innerhalb der Behandlungskammer 2, wobei sich je nach Ansteuerung der einzelnen Einzelstrahler 8 unterschiedliche Intensitätsverteilungen der abgestrahlten Mikrowellenstrahlung innerhalb der Behandlungskammer 2 ergeben.

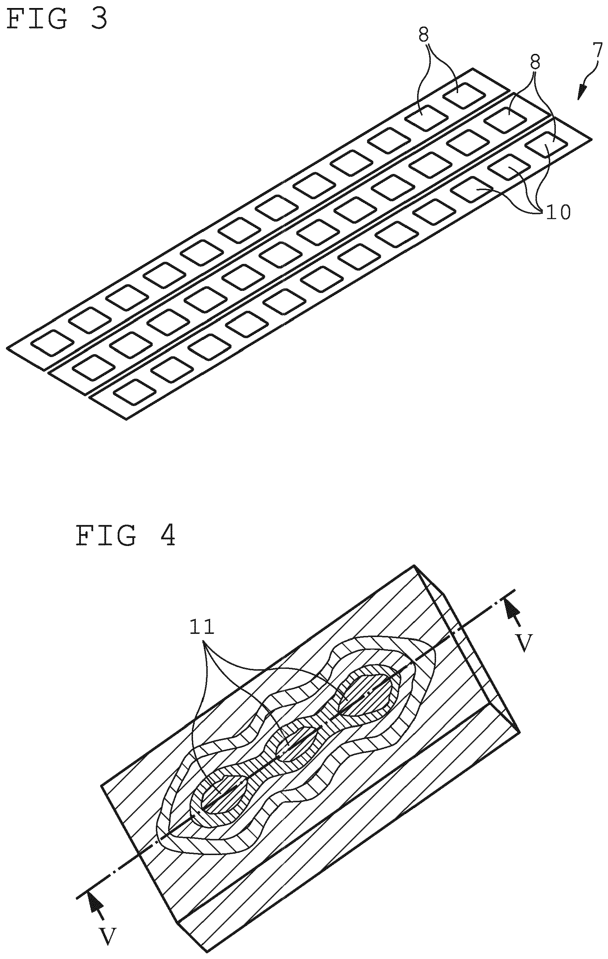

In Figur 3 ist lediglich exemplarisch ein Ausführungsbeispiel der Gruppenantenne 7 dargestellt. Die Gruppenantenne 7 weist insgesamt 36 Einzelstrahler 8 auf, die matrixförmig in drei Reihen und zwölf Zeilen angeordnet sind. Jeder Einzelstrahler 8 ist als Patchantenne ausgebildet und weist an einer dem zu behandelnden Objekt 5 in der Behandlungskammer 2 zugewandte rechteckförmige Metallplatte 10 auf, die zur Abstrahlung von Mikrowellenstrahlung angeregt werden kann. Die Abmessungen einer Längsseite der Metallplatte 10 der Einzelstrahler 8 sind an die charakteristische Wellenlänge I der Mikrowellenstrahlung angepasst, die mit den Einzelstrahlern 8 abgestrahlt wird.

Jedem Einzelstrahler 8 ist eine in den Figuren nicht gesondert dargestellte Einrichtung zur Veränderung und Anpassung einer Phase bzw. eines Phasenwinkels und gegebenenfalls einer Amplitude der mit dem Einzelstrahler 8 abgestrahlten Mikrowellenstrahlung zugeordnet, sodass für jeden Einzelstrahler 8 der Gruppenantenne 7 dessen Phase und die Amplitude der abgestrahlten Mikrowellenstrahlung frei vorgegeben werden kann. Dadurch kann eine Intensitätsverteilung eines Strahlungsfeldes, welches sich durch die Überlagerung der Mikrowellenstrahlung der einzelnen Einzelstrahler 8 ergibt, vielseitig beeinflusst und beispielsweise an unterschiedliche Objekte oder verschiedene Behandlungsmethoden angepasst werden.

In den Figuren 4 bis 11 sind exemplarisch vier verschiedene Abstrahlungsmodi dargestellt, die durch eine geeignete Ansteuerung von der Mikrowellensteuereinrichtung 9 mit der in den Figuren 1 bis 3 dargestellten Gruppenantenne 7 in der Behandlungskammer 2 realisiert werden können.

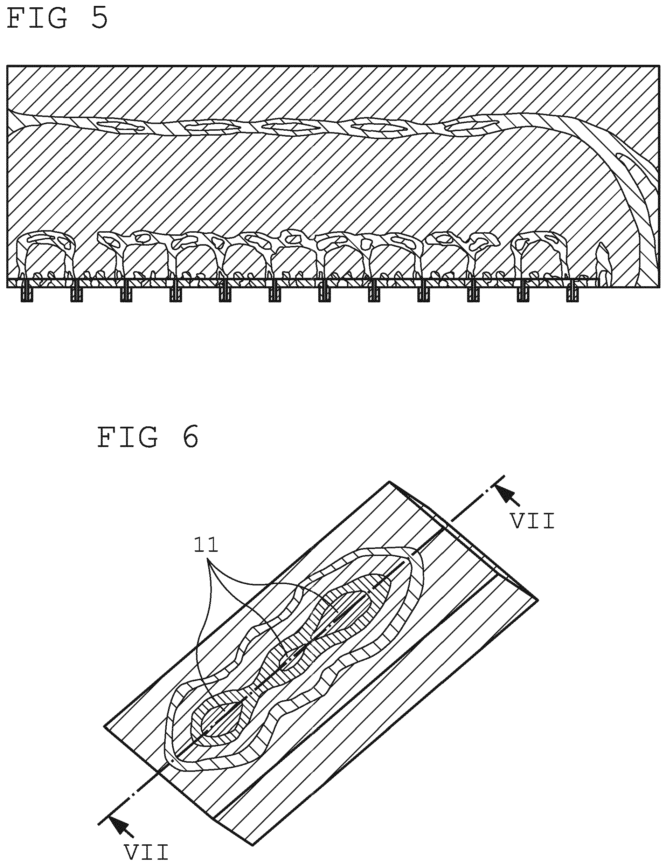

In den Figuren 4 und 5 werden eine perspektivische Ansicht sowie eine Schnittansicht eines ersten Abstrahlungsmodus dargestellt, bei welchem die Intensität und die Phase aller Einzelstrahler 8 identisch übereinstimmend vorgegeben ist und sich eine in Figur 5 gezeigte zunächst homogene Abstrahlung der Mikrowellenstrahlung ausbildet, wobei sich dann innerhalb der Behandlungskammer 2 mehrere durch die Abmessungen der Behandlungskammer 2 vorgegebene Intensitätsmaxima 11 ausbilden, die jedoch alle auf das zu behandelnde Objekt ausgerichtet und gleichmäßig voneinander beabstandet sind. In Figur 5 ist eine Schnittansicht durch eine E-Feld-Verteilung dargestellt, die bei der in Figur 4 gezeigten räumlichen Verteilung der abgestrahlten Mikrowellenleistungsdichte auftritt.

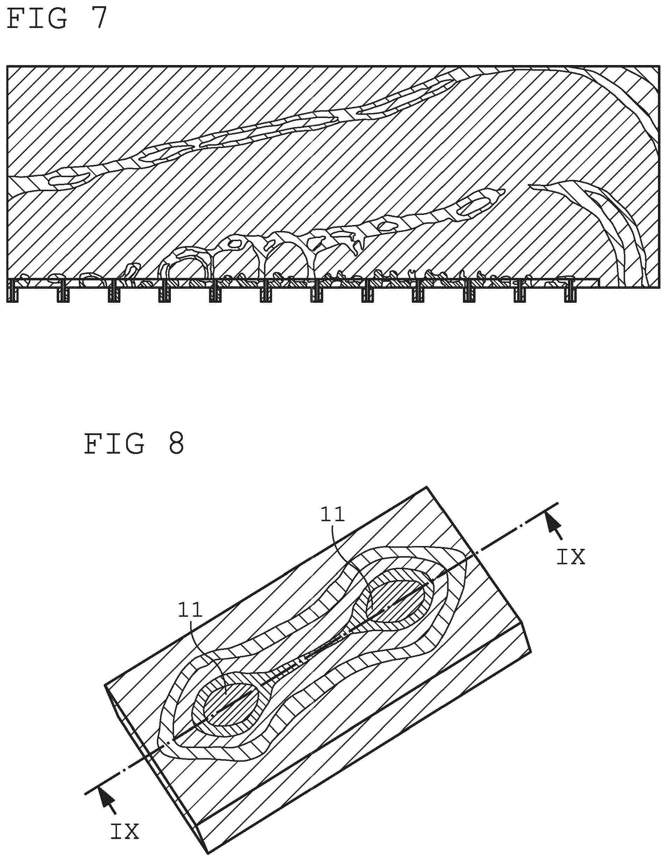

In den Figuren 6 und 7 werden eine perspektivische Ansicht und eine Schnittansicht eines zweiten Abstrahlungsmodus dargestellt, bei welchem die Phase der Einzelstrahler 8 innerhalb jeder Zeile gleich ist, aber für die zwölf Zeilen eine zeitlich aufeinanderfolgende Phasenverschiebung vorgegeben ist. Dadurch bildet sich in einer Richtung, die bei den in den Figuren 1 bis 3 gezeigten Ausführungsbeispielen quer zu einer Förderrichtung der Objekte 5 durch die Behandlungskammer 2 gerichtet ist, eine voneinander abweichende Ausgestaltung und Verteilung der Intensitätsmaxima 11 aus.

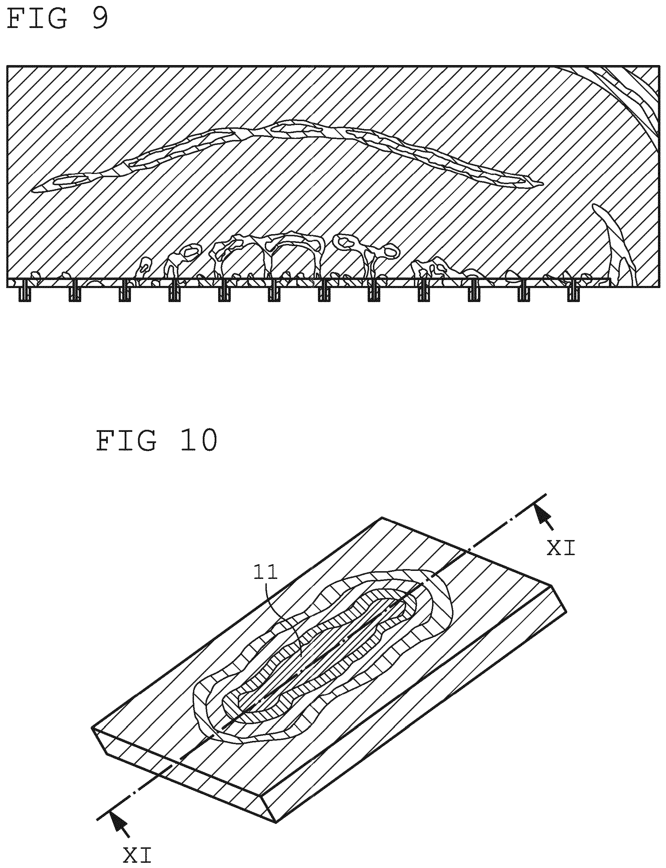

In den Figuren 8 und 9 werden eine perspektivische Ansicht und eine Schnittansicht eines dritten Abstrahlungsmodus dargestellt, bei welchem die Phase der Einzelstrahler 8 von den mittleren Zeilen aus nach außen hin jeweils etwas verzögert ist, wobei sich eine auf zwei Intensitätsmaxima 11 beschränkte Strahlungsverteilung in der Behandlungskammer 2 ergibt.

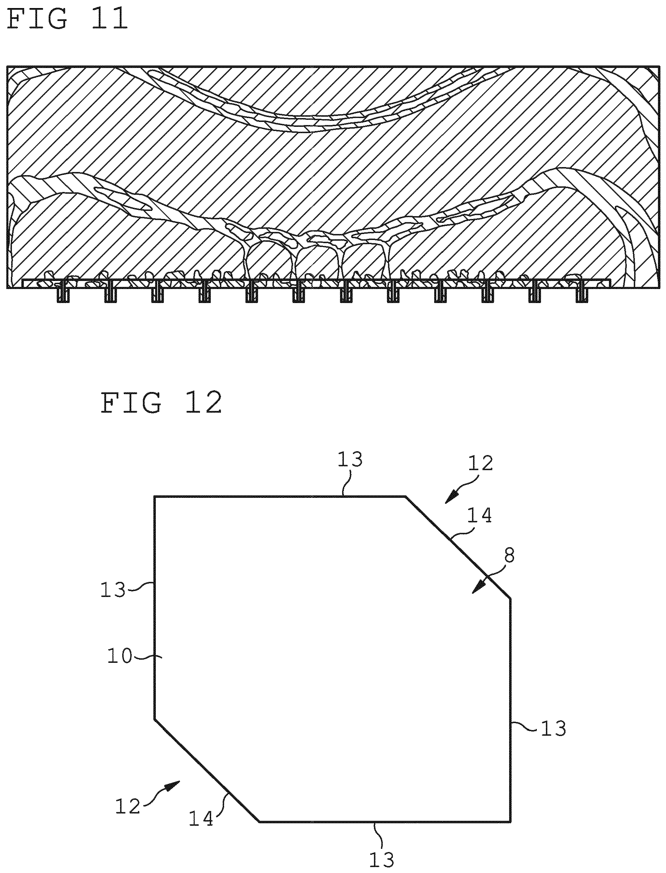

In den Figuren 10 und 11 werden eine perspektivische Ansicht und eine Schnittansicht eines vierten Abstrahlungsmodus dargestellt, bei welchem die Phase der Einzelstrahler 8 von den mittleren Zeilen aus nach außen hin jeweils etwas vorauseilend vorgegeben ist, wobei sich eine auf ein einzelnes, sehr breites Intensitätsmaximum 11 beschränkte Strahlungsverteilung in der Behandlungskammer 2 ergibt.

In Figur 12 ist exemplarisch eine schematische Draufsicht auf einen Einzelstrahler 8 dargestellt. Die Metallplatte 10 des Einzelstrahlers 8 weist eine näherungsweise quadratische Grundform mit Abmessungen von etwa 3 cm x 3 cm auf. Bei zwei gegenüberliegenden Eckbereichen 12 weist die Metallplatte 10 keine Ecken, sondern in einem Winkel von 45° relativ zu den angrenzenden Seitenkanten 13 verlaufende Diagonale 14 auf.

Mit derartigen Einzelstrahlern 8 können in vorteilhafter Weise zirkular polarisierte Mikrowellen mit einer Frequenz von 2.45 GHz erzeugt und abgestrahlt werden.

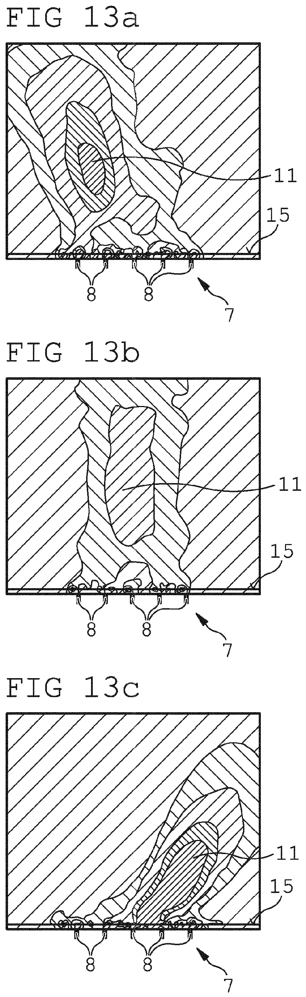

In den Figuren 13 a) bis c) sind verschiedene Abstrahlcharakteristika für eine Gruppenantenne 7 dargestellt, die aus einer matrixförmigen ebenen Anordnung von 5 x 5 Einzelstrahlern 8 gemäß Figur 12 zusammengesetzt ist. Die in Figur 13 a) dargestellte Schnittansicht zeigt eine Intensitätsverteilung für eine Mikrowellenabstrahlung, bei der die Abstrahlrichtung von einem Betrachter aus nach links relativ zu einer Lotrechten auf eine Anordnungsebene 15 der einzelnen Einzelstrahler 8 der Gruppenantenne 7 verschwenkt ist. Durch die Ansteuerung der einzelnen Einzelstrahler 8 wird nicht nur die Abstrahlrichtung beeinflusst, sondern auch ein vergleichsweise breites Intensitätsmaximum 11 in einem Abstand von der Anordnungsebene 15 erzeugt. Bei der in Figur 13 b) exemplarisch dargestellten Abstrahlcharakteristik wird eine in Richtung der Lotrechten auf die Anordnungsebene 15 der einzelnen Einzelstrahler 8 der Gruppenantenne 7 gerichtete Abstrahlung erzeugt, wobei in der Nähe der Gruppenantenne 7 kein ausgeprägtes Intensitätsmaximum 11 erzeugt wird.

Dagegen wird bei der in Figur 13 c) dargestellten Abstrahlcharakteristik eine von einem Betrachter aus nach rechts verschwenkte Abstrahlrichtung mit einem sehr deutlich ausgeprägten und nahe an der Anordnungsebene 15 der einzelnen Einzelstrahler 8 der Gruppenantenne 7 befindlichen Intensitätsmaximum erzeugt.

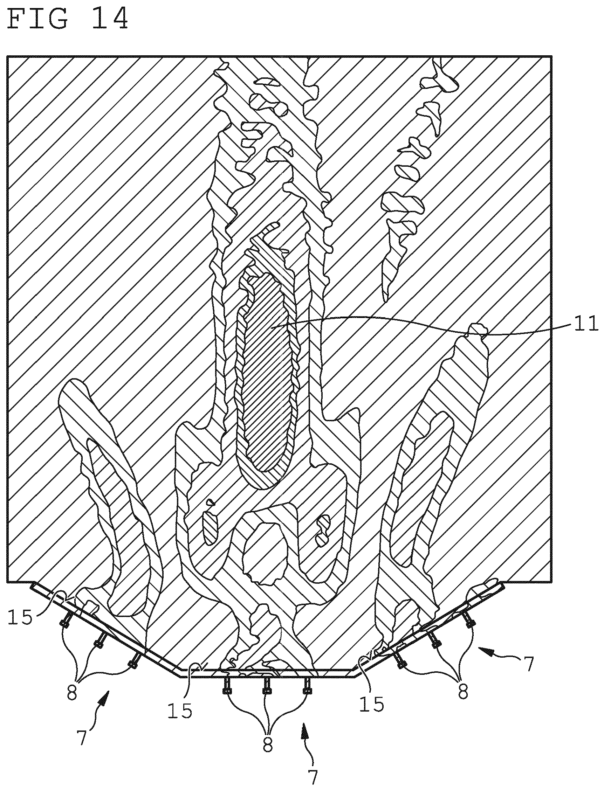

Diese lediglich exemplarisch dargestellten Abstrahlcharakteristika belegen, dass es mit einer erfindungsgemäßen Gruppenantenne 7 möglich ist, durch eine geeignete Ansteuerung der einzelnen Einzelstrahler 8 sowohl die Abstrahlrichtung als auch die Ausbildung eines Intensitätsmaximums 11 und dessen Abstand zu der Anordnungsebene 15 der Einzelstrahler 8 der Gruppenantenne 7 zu beeinflussen und in vorteilhafter Weise für eine betreffende Anwendung vorzugeben. In Figur 14 ist lediglich beispielhaft eine Abstrahlcharakteristik für eine Anordnung von drei Gruppenantennen 7 mit jeweils 3 x 6 matrixförmig angeordneten Einzelstrahlern 8 dargestellt. In der gezeigten Schnittansicht verläuft die Schnittebene durch jeweils drei Einzelstrahler 8 der drei Gruppenantennen 7. Die Drei Gruppenantennen 7 sind so nebeneinander angeordnet, dass die jeweiligen Anordnungsebenen 15 in einem Winkel von 30° jeweils zu der benachbarten Gruppenantenne 7 geneigt angeordnet sind. Mit einer derartigen Anordnung von drei Gruppenantennen 7 lässt sich die in Figur 14 in einer Schnittansicht dargestellte Intensitätsverteilung der von den drei Gruppenantennen 7 abgestrahlten Mikrowellenleistung erzeugen. In einem mittleren Bereich wird etwa 30 cm oberhalb der mittleren Gruppenantenne 7 ein deutlich ausgeprägtes Intensitätsmaximum 11 erzeugt. Diese Abstrahlcharakteristik und insbesondere das Intensitätsmaximum 11 ist dabei ohne ein umgebendes Gehäuse erzeugt worden. Mit einer derartigen Anordnung von Gruppenantennen 7 kann in einem nicht durch ein elektrisch leitendes Gehäuse begrenzten Behandlungsraum in der Nähe der Gruppenantennen 7 ein Intensitätsmaximum 11 erzeugt werden, welches für die Erzeugung und Ausbildung eines Plasmas ausreicht und verwendet werden kann.

## Patentansprüche

1. Mikrowellenbehandlungseinrichtung (1) mit einer Mikrowellenabstrahleinrichtung, mit welcher Mikrowellenstrahlung in einen Behandlungsraum (2) eingestrahlt oder darin abgestrahlt werden kann, wobei die Mikrowellenabstrahleinrichtung mindestens eine Gruppenantenne (7) mit einer Anzahl von Einzelstrahlern (8) sowie eine Mikrowellensteuereinrichtung (9) aufweist, mit welcher für jeden Einzelstrahler (8) der mindestens einen Gruppenantenne (7) eine Abstrahlcharakteristik vorgegeben werden kann, wobei die Einzelstrahler (8) der mindestens einen Gruppenantenne (7) jeweils als Patchantenne ausgebildet sind, **dadurch gekennzeichnet, dass** mit der Mikrowellensteuereinrichtung (9) für jeden Einzelstrahler (8) eine Phase der Mikrowellenabstrahlung vorgegeben werden kann, wobei die Mikrowellensteuereinrichtung (9) für jeden Einzelstrahler (8) eine zugeordnete Einrichtung zur Veränderung und Anpassung einer Phase aufweist, mit der die Phase der einem Einzelstrahler (8) zugeführten elektromagnetischen Welle beeinflusst und verändert werden kann.

2. Mikrowellenbehandlungseinrichtung (1) nach Anspruch 1, wobei mit der Mikrowellensteuereinrichtung (9) für jeden Einzelstrahler (8) eine Amplitude der Mikrowellenabstrahlung vorgegeben werden kann.

3. Mikrowellenbehandlungseinrichtung (1) nach Anspruch 1 oder Anspruch 2, wobei mit der Mikrowellensteuereinrichtung (9) für jeden Einzelstrahler (8) innerhalb eines Frequenzbereichs eine Frequenz der Mikrowellenabstrahlung vorgegeben werden kann.

4. Mikrowellenbehandlungseinrichtung (1) nach einem der vorausgehenden Ansprüche, wobei mindestens eine Gruppenantenne (7) innerhalb eines eine Behandlungskammer (2) umgebenden Gehäuses (3) aus einem elektrisch leitenden Material angeordnet ist.

5. Mikrowellenbehandlungseinrichtung (1) nach Anspruch 4, wobei die Behandlungskammer (2) eine Eingangsöffnung und eine Ausgangsöffnung zum Einbringen und zum Herausbringen des zu behandelnden Objekts (5) sowie eine Fördereinrichtung aufweist, mit welcher das zu behandelnde Objekt (5) durch die Eingangsöffnung in die Behandlungskammer (2) und nach einer Behandlung durch die Ausgangsöffnung aus der Behandlungskammer (2) heraus befördert werden kann.

6. Mikrowellenbehandlungseinrichtung (1) nach einem der vorangehenden Ansprüche, wobei mehrere Gruppenantennen (7) so relativ zu einem Behandlungsraum angeordnet sind, dass das zu behandelnde Objekt (5) aus unterschiedlichen Richtungen mit der jeweils von einer Gruppenantenne (7) abgestrahlten Mikrowellenstrahlung bestrahlt werden kann.

7. Mikrowellenbehandlungseinrichtung (1) nach einem der vorangehenden Ansprüche, wobei eine Antennenlinseneinrichtung zwischen der mindestens einen Gruppenantenne (7) und dem zu behandelnden Objekt (5) angeordnet ist, mit welchem von der Gruppenantenne (7) oder von mindestens einem Einzelstrahler (8) der Gruppenantenne (7) abgestrahlte Mikrowellenstrahlung umgelenkt oder fokussiert werden kann.

8. Mikrowellenbehandlungseinrichtung (1) nach Anspruch 5, die mindestens eine Antileckagegruppenantenne aufweist, die derart ausgerichtet und ansteuerbar ist, dass durch die Eingangsöffnung und/oder durch die Ausgangsöffnung austretende Mikrowellenstrahlung der mindestens einen Gruppenantenne (7) destruktiv überlagert und die austretende Intensität der Mikrowellenstrahlung dadurch reduziert wird.

## Claims

1. Microwave treatment device (1) with a microwave emission device, by which microwave radiation can be radiated into a treatment chamber (2) or emitted therein, wherein the microwave emission device comprises at least one array antenna (7) having a plurality of individual emitters (8) and a microwave control device (9) by which an emission characteristic can be specified for each individual emitter (8) of the at least one array antenna (7), wherein the individual emitters (8) of the at least one array antenna (7) are in each case designed as a patch antenna, **characterized in that** a phase of the microwave emission can be specified for each individual emitter by the microwave control device (9), wherein the microwave control device (9) comprises an allocated device for each individual emitter (8) for changing and adjusting a phase, by means of which the phase of the electromagnetic wave supplied to an individual emitter (8) can be influenced and changed.

2. Microwave treatment device (1) according to claim 1, wherein an amplitude of a microwave emission can be specified for each individual emitter (8) by the microwave control device (9).

3. Microwave treatment device (1) according to claim 1 or claim 2, wherein the microwave control device (9) can be used to specify a frequency of the microwave radiation for each individual emitter (8) within a frequency range.

4. Microwave treatment device (1) according to one of the preceding claims, wherein at least one array antenna (7) is arranged inside a housing (3) that is made of an electrically conductive material and surrounds the treatment chamber (2).

5. Microwave treatment device (1) according to claim 4, wherein the treatment chamber (2) comprises an inlet opening and an outlet opening for introducing and removing the object (5) to be treated, and a conveying device by which the object (5) to be treated can be conveyed through the inlet opening into the treatment chamber (2) and, after treatment, through the outlet opening out of the treatment chamber (2).

6. Microwave treatment device (1) according to one of the preceding claims, wherein a plurality of array antennas (7) are arranged relative to a treatment space in such a way that the object (5) to be treated can be irradiated from different directions by the microwave radiation emitted by a respective array antenna (7).

7. Microwave treatment device (1) according to one of the preceding claims, wherein an antenna lens device is arranged between the at least one array antenna (7) and the object (5) to be treated, by means of which the microwave radiation emitted by the array antenna (7) or by at least one individual emitter (8) of the array antenna (7) can be deflected or focused.

8. Microwave treatment device (1) according to claim 5, comprising at least one anti-leakage array antenna which is oriented and actuatable such that microwave radiation of the at least one array antenna (7) emerging through the inlet opening and/or through the outlet opening undergoes destructive superposition, and an emerging emitted intensity of the microwave radiation is reduced as a result.

## Revendications

1. Dispositif de traitement par micro-ondes (1) comprenant un dispositif d'émission de micro-ondes, avec lequel un rayonnement micro-ondes peut être émis ou rayonné dans une chambre de traitement (2), le dispositif d'émission de micro-ondes comportant au moins une antenne collective (7) avec un certain nombre d'émetteurs individuels (8) et un dispositif de commande à micro-ondes (9) permettant de prédéfinir une caractéristique d'émission pour chaque émetteur individuel (8) de l'au moins une antenne collective (7), les émetteurs individuels (8) de l'au moins une antenne collective (7) étant chacun conçus comme des antennes patch, **caractérisé en ce que** le dispositif de commande à micro-ondes (9) permet de prédéfinir une phase du rayonnement micro-ondes pour chaque émetteur individuel, le dispositif de commande à micro-ondes (9) comportant pour chaque émetteur individuel (8) un dispositif associé pour modifier et adapter une phase, à l'aide duquel la phase de l'onde électromagnétique amenée à un émetteur individuel (8) peut être influencée et modifiée.

2. Dispositif de traitement par micro-ondes (1) selon la revendication 1, dans lequel le dispositif de commande des micro-ondes (9) permet de prédéfinir une amplitude du rayonnement micro-ondes pour chaque émetteur individuel (8).

3. Dispositif de traitement par micro-ondes (1) selon la revendication 1 ou la revendication 2, dans lequel le dispositif de commande des micro-ondes (9) permet de prédéfinir une fréquence du rayonnement micro-ondes pour chaque émetteur individuel (8) dans une plage de fréquences.

4. Dispositif de traitement par micro-ondes (1) selon l'une des revendications précédentes, dans lequel au moins une antenne collective (7) est disposée à l'intérieur d'un boîtier (3) en matériau électriquement conducteur entourant une chambre de traitement (2).

5. Dispositif de traitement par micro-ondes (1) selon la revendication 4, dans lequel la chambre de traitement (2) comporte une ouverture d'entrée et une ouverture de sortie pour introduire et retirer l'objet à traiter (5) ainsi qu'un dispositif de transport permettant de transporter l'objet à traiter (5) à travers l'ouverture d'entrée dans la chambre de traitement (2) et, après traitement, à travers l'ouverture de sortie hors de la chambre de traitement (2).

6. Dispositif de traitement par micro-ondes (1) selon l'une des revendications précédentes, dans lequel plusieurs antennes collectives (7) sont disposées par rapport à un espace de traitement de telle sorte que l'objet à traiter (5) puisse être irradié dans différentes directions par le rayonnement micro-ondes émis respectivement par une antenne collective (7).

7. Dispositif de traitement par micro-ondes (1) selon l'une des revendications précédentes, dans lequel un dispositif à lentille d'antenne est disposé entre au moins une antenne collective (7) et l'objet à traiter (5), grâce auquel le rayonnement micro-ondes émis par l'antenne collective (7) ou d'au moins un émetteur individuel (8) de l'antenne collective (7).

8. Dispositif de traitement par micro-ondes (1) selon la revendication 5, qui comporte au moins une antenne collective anti-fuites qui est orientée et peut être commandée de telle sorte que le rayonnement micro-ondes sortant par l'ouverture d'entrée et/ou par l'ouverture de sortie de la au moins une antenne collective (7) se superpose de manière destructive et que l'intensité sortante du rayonnement micro-ondes soit ainsi réduite.
